# EUROPÄISCHE PATENTANMELDUNG

(11) **EP 4 283 752 A2**
(43) Veröffentlichungstag der Anmeldung: **29.11.2023**
(21) Anmeldenummer: 23174629.8
(22) Anmeldetag: 22.05.2023
(51) Int. Cl.: H01M 10/42

(54) **VORRICHTUNG UND VERFAHREN ZUR PRÜFUNG EINER BATTERIE**

(30) Priorität: 23.05.2022 DE 102022112996
(71) Anmelder: Hahn Automation GmbH, 55494 Rheinböllen (DE)
(72) Erfinder: Sulzbacher, Martin, 55444 Dörrebach (DE)
(74) Vertreter: Janke Scholl Patentanwälte PartG mbB

(57) **Zusammenfassung**

Vorrichtung zur Prüfung einer Batterie, mit einem Transportsystem (4), wobei das Transportsystem (4) zum Aufnehmen der Batterie (54), zum Transport der Batterie (54) hin zu einer Prüfposition (12) und zum Abtransport der Batterie (54) aus der Prüfposition (12) eingerichtet ist; mit einer Schnittstelle (14), wobei die Schnittstelle (14) zur Versorgung der in der Prüfposition (12) angeordneten Batterie (54) mit elektrischer Leistung eingerichtet ist und wobei die Schnittstelle (14) zur Versorgung der in der Prüfposition (12) angeordneten Batterie (54) mit Gas eingerichtet ist.

## Beschreibung

Die vorliegende Erfindung betrifft eine Vorrichtung und ein Verfahren zur Prüfung einer Batterie.

Moderne Kraftfahrzeuge werden zunehmend mit vollständig elektromotorischem Antrieb oder Hybridantrieb ausgestattet. Dabei dient eine Batterie, die auch als Traktionsbatterie bezeichnet wird, zur Versorgung eines Elektromotors oder mehrerer Elektromotoren mit elektrischer Leistung, um das betreffende Fahrzeug mittels des Elektromotors oder mittels mehrerer Elektromotoren anzutreiben.

Während der Herstellung derartiger Batterien werden diese vielfältigen Tests unterzogen. Unter anderem findet eine Leistungsprüfung der Batterie statt, die die Funktionstüchtigkeit und Funktionssicherheit im Rahmen einer End-of-Line Prüfung sicherstellt. Dabei wird eine betreffende zu prüfende Batterie in kurzer Zeit mehrfach geladen und wieder entladen. Weiter kann die Batterie einer Hochvoltspannung zur Isolationsprüfung ausgesetzt werden.

Sofern ein Defekt der Batterie vorliegt, kann die Batterie in Brand geraten. Ein solcher Brand und die damit einhergehende Rauchentwicklung stellen eine große Gefahr für die in der Fertigungsumgebung befindlichen Personen und die zur Herstellung und Prüfung der Batterien verwendeten Fertigungseinrichtungen und Gebäude dar.

Vor diesem Hintergrund liegt der vorliegenden Erfindung die technische Problemstellung zugrunde, eine Vorrichtung und ein Verfahren zur Prüfung einer Batterie anzugeben, die die Sicherheit im Rahmen der Prüfung einer Batterie verbessern. Die voranstehend beschriebene, technische Problemstellung wird jeweils durch die unabhängigen Ansprüche gelöst. Weitere Ausgestaltungen der Erfindung ergeben sich aus den abhängigen Ansprüchen und der nachstehenden Beschreibung.

Gemäß einem ersten Aspekt betrifft die Erfindung eine Vorrichtung zur Prüfung einer Batterie, mit einem Transportsystem, wobei das Transportsystem zum Aufnehmen der Batterie, zum Transport der Batterie hin zu einer Prüfposition und zum Abtransport der Batterie aus der Prüfposition eingerichtet ist, mit einer Schnittstelle, wobei die Schnittstelle zur Versorgung der in der Prüfposition angeordneten Batterie mit elektrischer Leistung eingerichtet ist und wobei die Schnittstelle zur Versorgung der in der Prüfposition angeordneten Batterie mit Gas eingerichtet ist.

Insbesondere kann vorgesehen sein, dass die Vorrichtung zur gleichzeitigen Dichtigkeitsprüfung und Leistungsprüfung einer in der Prüfposition angeordneten Batterie eingerichtet ist, wobei die Schnittstelle sowohl zur Versorgung der in der Prüfposition angeordneten Batterie mit elektrischer Leistung als auch zur Einbringung von Gas in die in der Prüfposition angeordnete Batterie eingerichtet ist.

Die gleichzeitige Prüfung der Dichtigkeit und der Leistung hat den Vorteil, dass innerhalb der Batterie durch das Gas eine nur schwer entflammbare bzw. brandhemmende Atmosphäre geschaffen wird, sodass die Brandentwicklung und Rauchentwicklung im Falle eines Defekts gehemmt werden können.

Gemäß einer Ausgestaltung der Vorrichtung kann vorgesehen sein, dass die Vorrichtung eine auf das Transportsystem absenkbare Brandschutzhaube zum Abschirmen der Batterie gegenüber einer Umgebung aufweist.

Die Brandschutzhaube ermöglicht eine Eindämmung und Begrenzung einer Brand- und Rauchentwicklung, sofern eine zu prüfende Batterie während einer Leistungsprüfung in Brand gerät.

Eine solche in Brand geratene Batterie mit darauf abgesenkter Brandschutzhaube bzw. mit auf das Transportsystem abgesenkter Brandschutzhaube kann mittels des Transportsystems aus der Prüfposition abtransportiert werden. Beispielsweise kann vorgesehen sein, dass die in Brand geratene Batterie in einen evakuierbaren Schutzraum mit Rauchgasabzug oder eine evakuierbare Schutzzelle mit Rauchgasabzug oder in einen Außenbereich transportiert wird, um ein Löschen und/oder ein kontrolliertes Abbrennen der Batterie zu ermöglichen.

Die erfindungsgemäße Vorrichtung ist insbesondere ein Prüfstand zur Leistungsprüfung bzw. End-of-Line Prüfung einer Batterie.

Wenn vorliegend von einer Batterie gesprochen wird, so handelt es sich dabei insbesondere um eine Traktionsbatterie für ein Kraftfahrzeug, die zur Versorgung eines oder mehrere Elektromotoren des Kraftfahrzeugs mit elektrischer Leistung vorgesehen ist. Das Kraftfahrzeug ist dabei insbesondere ein rein elektromotorisch angetriebenes Kraftfahrzeug oder ein Hybrid-Fahrzeug.

Die Batterie kann ein Modul oder mehrere Module aufweisen. Ein Modul kann mehrere Zellen bzw. Batteriezellen aufweisen. Das erfindungsgemäße Verfahren und die erfindungsgemäße Vorrichtung können zur Prüfung von Modulen oder Zellen verwendet werden, insbesondere zur Prüfung einzelner Module oder Zellen verwendet werden.

Eine zu prüfende Batterie selbst ist nicht Teil der erfindungsgemäßen Vorrichtung, sondern wird lediglich mittels der erfindungsgemäßen Vorrichtung geprüft.

Die Schnittstelle zur Versorgung der in der Prüfposition angeordneten Batterie mit elektrischer Leistung kann sowohl zum Laden als auch zum Entladen der Batterie vorgesehen sein.

Die Schnittstelle kann insbesondere dazu vorgesehen sein, die in der Prüfposition angeordnete Batterie z.B. mit einer elektrischen Leistung von 1 kW bis 500 kW (Kilowatt) zu versorgen, insbesondere mit einer Ladeleistung von von 1 kW bis 500 kW (Kilowatt) zu versorgen.

Im Rahmen einer Hochvolt-Prüfung kann die Batterie z.B. mit bis zu 7000 Volt beaufschlagt werden.

Die Brandschutzhaube kann automatisiert absenkbar ausgeführt sein.

Beispielsweise kann vorgesehen sein, dass ein Absenken der Brandschutzhaube ausgelöst wird, sofern eine Steuerung der Vorrichtung anhand einer oder mehrerer Sensoren eine Gefahrensituation, wie eine Brandentwicklung und/oder Rauchentwicklung, detektiert. Die Vorrichtung kann daher eine Steuerung aufweisen, die zum automatisierten Absenken der Brandschutzhaube eingerichtet ist.

Alternativ oder ergänzend kann vorgesehen sein, dass das Absenken der Brandschutzhaube durch einen Maschinenbediener auslösbar sein kann. Beispielsweise kann ein Schaltelement, wie ein Druckknopf, ein Schalter, ein Hebel oder dergleichen, vorgesehen sein, um das Absenken der Brandschutzhaube manuell auszulösen. Sofern ein Maschinenbediener eine Gefahrensituation, wie eine Brandentwicklung und/oder eine Rauchentwicklung erkennt, und ein automatisiertes Absenken der Brandschutzhaube fehlschlägt bzw. nicht erfolgt, kann der Maschinenbediener durch die Betätigung des Schaltelements das Absenken der Brandschutzhaube auslösen.

Es kann vorgesehen sein, dass die Brandschutzhaube in vertikaler Richtung betrachtet oberhalb der Prüfposition in einer Wartestellung positionierbar ist und aus der Wartestellung auf die zu prüfende, in der Prüfposition angeordnete Batterie absenkbar ist bzw. auf das Transportsystem absenkbar ist.

Es kann vorgesehen sein, dass die Brandschutzhaube in vertikaler Richtung betrachtet mit einem seitlichen Versatz zur Prüfposition in einer Wartestellung positionierbar ist und aus der Wartestellung auf die zu prüfende, in der Prüfposition angeordnete Batterie absenkbar ist bzw. auf das Transportsystem absenkbar ist.

Sofern eine Prüfung der Batterie fehlerfrei abläuft, verbleibt die Brandschutzhaube in der Wartestellung. Es kann daher vorgesehen sein, dass eine Mehrzahl von Batterien mittels des Transportsystems nacheinander in die Prüfposition bewegt, einer Leistungsprüfung unterzogen und wieder mittels des Transportsystems abtransportiert werden, ohne, dass es zu einem Absenken der Brandschutzhaube kommt. Die Brandschutzhaube wird daher nur bei Bedarf, d. h. beim Vorliegen einer Gefahrensituation, auf das Transportsystem abgesenkt, um die betreffende in Brand geratene Batterie, die sich in der Prüfposition befindet, gegenüber der Umgebung abzuschirmen.

Gemäß einer weiteren Ausgestaltung der Vorrichtung kann vorgesehen sein, dass die Brandschutzhaube in einer rein linearen Bewegung auf die zu prüfende, in der Prüfposition angeordnete Batterie absenkbar ist bzw. auf das Transportsystem absenkbar ist. So kann eine kostengünstige und effiziente konstruktive Lösung angegeben werden, die ein zügiges Abschirmen bzw. Kapseln der Batterie gegenüber einer Umgebung ermöglicht.

Die Vorrichtung kann eine Handhabungseinrichtung aufweisen, wobei die Handhabungseinrichtung zum automatisierten Absenken und Anheben der Brandschutzhaube eingerichtet ist.

Eine solche Handhabungseinrichtung kann beispielsweise eine oder mehrere numerisch gesteuerte Achsen aufweisen oder einen Roboter aufweisen, um die Brandschutzhaube zu halten und zu bewegen.

Die Handhabungseinrichtung kann eine Kupplung zum Koppeln der Brandschutzhaube mit der Handhabungseinrichtung und zum Entkoppeln der Brandschutzhaube von der Handhabungseinrichtung aufweisen. Die Kupplung kann beispielsweise eine mechanische Kupplung sein.

Insbesondere kann vorgesehen sein, dass an der Handhabungseinrichtung einen aktuierbares Kupplungselement, wie ein Rastelement, ein Haken, ein Stift oder dergleichen, vorgesehen ist, dass formschlüssig in ein Formelement oder eine Hinterschneidung, die an der Brandschutzhaube gebildet ist, eingreift, um die Brandschutzhaube formschlüssig mit der Handhabungseinrichtung zu koppeln. Es kann daher insbesondere vorgesehen sein, dass das aktuierbare Kupplungselement aus einer Freigabeposition, in der die Brandschutzhaube nicht mit der Handhabungseinrichtung gekoppelt ist, in eine Kupplungsposition, in der die Brandschutzhaube formschlüssig mit der Handhabungseinrichtung gekoppelt ist, bewegbar ist, um die Brandschutzhaube an der Handhabungseinrichtung zu fixieren bzw. um die Brandschutzhaube mit der Handhabungseinrichtung zu koppeln.

Gemäß alternativer Ausgestaltungen kann vorgesehen sein, dass eine solche Handhabungseinrichtung alternativ oder ergänzend eine magnetische Kupplung aufweist, um die Brandschutzhaube mit der Handhabungseinrichtung zu koppeln oder die Brandschutzhaube von der Handhabungseinrichtung zu entkoppeln.

Alternativ oder ergänzend kann vorgesehen sein, dass die Handhabungseinrichtung eine Greifeinrichtung aufweist, um die Brandschutzhaube zu greifen und um diese anzuheben oder abzusenken. Insbesondere kann eine solche Greifeinrichtung dazu eingerichtet sein, die Brandschutzhaube zweiseitig oder mehrseitig zu umgreifen oder eines oder mehrere Formelemente der Brandschutzhaube zweiseitig oder mehrseitig zu umgreifen, um die Brandschutzhaube anzuheben oder abzusenken.

Für den Fall, dass die Prüfung einer Batterie oder mehrerer Batterien fehlerfrei, d. h. im vorliegenden Sinne ohne eine Brand- und/oder Rauchentwicklung erfolgt, ist die Handhabungseinrichtung dazu eingerichtet, die Brandschutzhaube für den Zeitraum dieses fehlerfreien Betriebs dauerhaft in der Warteposition bzw. der Wartestellung zu halten.

Es kann vorgesehen sein, dass die Handhabungseinrichtung einen in vertikaler Richtung betrachtet oberhalb der Prüfposition angeordneten Träger aufweist, wie ein Portal oder einen Kragarm, an dem eine Achse der Handhabungseinrichtung zum Absenken und Anheben der Brandschutzhaube angeordnet ist, wobei die Achse insbesondere eine Linearachse ist. Die vorgenannte konstruktive Ausgestaltung ermöglicht eine zuverlässige und kostengünstige Positionierung der Brandschutzhaube oberhalb der Prüfposition. Insbesondere in Kombination mit einer Linearachse, die eine numerisch gesteuerte Achse sein kann, kann eine effiziente Automatisierung zum Anheben und Absenken sowie zum Halten der Brandschutzhaube in der Warteposition realisiert werden.

Die Linearachse kann ein Pneumatikzylinder sein. Die Linearachse kann ein Hydraulikzylinder sein. Die Linearachse kann ein servoelektrischer Spindelantrieb sein.

Die Brandschutzhaube kann einen feuerfesten Werkstoff aufweisen, mit einem feuerfesten Werkstoff beschichtet sein oder aus einem feuerfesten Werkstoff bestehen.

Die Brandschutzhaube kann in Skelettbauweise ausgeführt sein und ein Rahmenskelett mit flächigen Füllelementen aufweisen. Die flächigen Füllelementen können auch als Brandschutzplatten oder Brandschutzmatten bezeichnet werden.

Das Rahmenskelett kann zumindest teilweise aus einem metallischen Werkstoff gebildet sein, wie z.B. Aluminium, Aluminiumlegierungen oder dergleichen. Die Brandschutzplatten oder Brandschutzmatten können aus einem nicht brennbaren Füllmaterial, insbesondere mineralischem Brandschutzmaterial, oder aus einem nicht brennbaren Werkstoff bestehen oder ein nicht brennbares Füllmaterial oder einen nicht brennbaren Werkstoff aufweisen.

Die Brandschutzplatten oder Brandschutzmatten können lösbar und austauschbar an dem Rahmenskelett gehalten sein, insbesondere mit dem Rahmenskelett verschraubt sein.

Die Brandschutzhaube kann im Wesentlichen quaderförmig sein und eine der Prüfposition zugewandte Öffnung aufweisen.

Die Brandschutzhaube kann beispielsweise eine Länge von ca. 20 cm bis ca. 350 cm aufweisen, insbesondere eine Länge von 100 cm - 250 cm aufweisen.

Die Brandschutzhaube kann beispielsweise eine Höhe von ca. 5 cm bis ca. 100 cm aufweisen, insbesondere eine Höhe von ca. 20 cm bis ca. 60 cm.

Die Brandschutzhaube kann beispielsweise eine Breite von ca. 10 cm bis ca. 250 cm aufweisen, insbesondere eine Breite von ca. 30 cm bis ca. 150 cm aufweisen.

Die Brandschutzhaube kann ein Gewicht von ca. 10 kg bis ca .250 kg aufweisen.

Die Brandschutzhaube kann zur Abschirmung eines Volumens von 0,001 m³ - 8,75 m³ gegenüber der Umgebung eingerichtet sein, insbesondere eines Volumens von 0,5 m³ - 2,25 m³ gegenüber der Umgebung eingerichtet sein.

Es kann vorgesehen sein, dass in der Brandschutzhaube eine Überdrucköffnung mit Filter ist oder mehrere Überdrucköffnungen mit Filter integriert sind, die bei großer Gasentwicklung vor einem Überdruck im Inneren der Brandschutzhaube schützen.

Die Überdrucköffnung kann ein Überdruckventil aufweisen.

Die Überdrucköffnungen können durch eine Porosität eines Materials der Brandschutzhaube gebildet sein, die einen Gasdurchsatz ab einem gewissen Innendruck zulässt, um den Überdruck zu reduzieren. Die Brandschutzhaube kapselt daher die Batterie im Wesentlichen vor der Umgebung, lässt jedoch einen Überdruckausgleich zu.

Die Schnittstelle kann eine erste Anschlussanordnung aufweisen, die an dem Transportsystem befestigt ist und die Schnittstelle kann eine zweite Anschlussanordnung aufweisen, die mit der ersten Anschlussanordnung verbindbar ist, wobei die erste Anschlussanordnung mittels des Transportsystems relativ zu der zweiten Anschlussanordnung bewegbar ist.

Die erste Anschlussanordnung und die zweite Anschlussanordnung bilden daher insbesondere die Schnittstelle, wobei die erste Anschlussanordnung und die zweite Anschlussanordnung insbesondere eine Anordnung von zueinander passenden Kontaktelementen, wie Buchsen oder Pins aufweisen, um eine oder mehrere lösbare Steckverbindungen herzustellen. Beispielsweise kann die erste Anschlussanordnung zwei oder mehr Buchsen aufweisen, während die zweite Anschlussanordnung zwei oder mehr in diese Buchsen passende Pins aufweist, oder umgekehrt, wobei die Anschlussanordnungen jeweils ein zueinander passendes Steckgesicht aufweisen.

Insbesondere kann vorgesehen sein, dass eine zu prüfende Batterie über Kabel bzw. Leitungen mit der ersten Anschlussanordnung verbunden wird, bevor die Batterie mittels des Transportsystems in die Prüfposition bewegt wird. Es kann vorgesehen sein, dass die erste Anschlussanordnung im Bereich einer der zweiten Anschlussanordnung abgewandten Seite mit der Batterie verbindbar ist bzw., soweit sich die Batterie in der Prüfposition befindet, mit der zu prüfenden Batterie verbunden ist. Ein Verbinden der zu prüfenden Batterie mit der ersten Anschlussanordnung kann automatisiert erfolgen.

Es kann vorgesehen sein, dass die Brandschutzhaube die erste Anschlussanordnung in einem auf das Transportsystem abgesenkten Zustand abdeckt und gegenüber der Umgebung abschirmt und die Brandschutzhaube insbesondere die zweite Anschlussanordnung in dem auf das Transportsystem abgesenkten Zustand nicht abdeckt.

Sofern sich die Brandschutzhaube in ihrem auf das Transportsystem abgesenkten Zustand befindet, deckt die Brandschutzhaube in diesem Fall daher sowohl die erste Anschlussanordnung als auch die zu prüfende Batterie ab. Dies hat den Vorteil, dass die zu prüfende Batterie in einem Gefahrenfall mit der ersten Anschlussanordnung verbunden bleiben kann und die Batterie in dem mit der ersten Anschlussanordnung verbundenen Zustand zusammen mit der ersten Anschlussanordnung gegenüber der Umgebung abgeschirmt bzw. gekapselt werden kann und mittels des Transportsystems aus der Prüfposition abtransportiert werden kann.

Es kann vorgesehen sein, dass die Prüfposition durch eine Tragstruktur vorgegeben ist. Eine solche Tragstruktur kann beispielsweise eine Parkposition für einen Transportwagen oder eine Halteposition für einen über ein Band beförderten, die Batterie tragenden Werkstückträger vorgeben.

Beispielsweise kann vorgesehen sein, dass die zweite Anschlussanordnung der Schnittstelle an der Tragstruktur befestigt ist. Die zweite Anschlussanordnung der Schnittstelle ist daher insbesondere stationär an der Tragstruktur angeordnet, während die erste Anschlussanordnung mittels des Transportsystems zusammen mit der Batterie bewegbar ist. Wenn vorliegend davon gesprochen wird, dass die zweite Anschlussanordnung stationär positioniert ist, so schließt dies nicht aus, dass die zweite Anschlussanordnung aktuierbare bzw. bewegbare Komponenten aufweist, die beispielsweise eine Hubbewegung oder Stellbewegung zum automatisierten Koppeln oder Entkoppeln der Schnittstelle aufweist.

Stationär bedeutet in diesem Fall daher, dass die zweite Anschlussanordnung mit ihren gegebenenfalls aktuierbaren Komponenten im Bereich der Prüfposition verbleibt bzw. im Bereich der Prüfposition an der Tragstruktur befestigt ist.

Die Schnittstelle kann automatisiert koppelbar und entkoppelbar sein, wobei die Schnittstelle insbesondere einen mechanischen Aktuator zum automatisierten Koppeln und Entkoppeln der Schnittstelle aufweist. Ein solcher mechanischer Aktuator kann beispielsweise ein elektrisch, pneumatisch oder hydraulisch betätigter Hubzylinder sein, um die erste Anschlussanordnung oder die zweite Anschlussanordnung aus einer Trennposition, in der die erste Anschlussanordnung und die zweite Anschlussanordnung voneinander entkoppelt sind, in eine Verbindungsposition, in der die erste Anschlussanordnung und die zweite Anschlussanordnung miteinander gekoppelt sind, zu bewegen.

Die Möglichkeit, die Schnittstelle automatisiert zu koppeln oder zu entkoppeln, hat den Vorteil, dass im Gefahrenfall eine Versorgung der Batterie mit elektrischer Leistung sofort automatisiert getrennt werden kann, in dem die erste Anschlussanordnung und die zweite Anschlussanordnung physisch auseinanderbewegt werden. Sofern die Brandschutzhaube dazu eingerichtet ist, in dem auf das Transportsystem abgesenkten Zustand sowohl die Batterie als auch die erste Anschlussanordnung abzuschirmen, ermöglicht das automatisierte Entkoppeln zudem ein zügiges Absenken der Brandschutzhaube, sofern die Schnittstelle im Absenkweg der Brandschutzhaube gebildet ist.

Es kann vorgesehen sein, dass der mechanische Aktuator zum automatisierten Koppeln und Entkoppeln der Schnittstelle an der Tragstruktur gehalten ist.

Gemäß einer weiteren Ausgestaltung der Vorrichtung kann mindestens eine mechanische Arretierung vorgesehen sein, um die zu prüfende Batterie und/oder das Transportsystem in der Prüfposition zu arretieren und/oder auszurichten. Die mechanische Arretierung kann insbesondere automatisiert koppelbar und entkoppelbar sein.

Die mechanische Arretierung kann beispielsweise zur formschlüssigen Arretierung der Batterie und/oder des Transportsystems und/oder zur formschlüssigen Positionierung der Batterie und/oder des Transportsystems in der Prüfposition eingerichtet sein.

Es kann vorgesehen sein, dass zumindest ein Teil der mechanischen Arretierung an der Tragstruktur befestigt ist. Beispielsweise kann ein Stellelement, das dazu eingerichtet ist, formschlüssig in eine Hinterschneidung oder in eine Öffnung des Transportsystems einzugreifen, an der Tragstruktur befestigt sein. Ein solches Stellelement kann beispielsweise mittels eines elektrisch, pneumatisch oder hydraulisch betätigten Hubzylinders aus einer Freigabeposition in eine Sperr- oder Zentrierposition bewegbar sein.

Es kann vorgesehen sein, dass die mechanische Arretierung zwei oder mehr Stellelemente aufweist.

Es kann vorgesehen sein, dass die mechanische Arretierung erste Stelleelemente zur Fixierung der Batterie und/oder des Transportsystems in der Prüfposition aufweist und dass die mechanische Arretierung zweite Stelleelemente zur Positionierung bzw. Zentrierung der Batterie und/oder des Transportsystems in der Prüfposition aufweist.

Das Transportsystem kann einen Transportwagen aufweisen.

Der Transportwagen kann Rollen aufweisen.

Der Transportwagen kann einen Antrieb zum automatischen oder zum teilautomatischen Verfahren bzw. Bewegen des Transportwagens aufweisen. Beispielsweise kann vorgesehen sein, dass der Transportwagen vollständig automatisiert hin zur Prüfposition und aus der Prüfposition verfahrbar ist.

Es kann vorgesehen sein, dass der Transportwagen mittels einer kabelgebundenen oder einer kabellosen Fernbedienung durch einen Mitarbeiter verfahrbar ist.

Es kann vorgesehen sein, dass der Transportwagen manuell bewegbar ist.

Der Transportwagen kann die erste Anschlussanordnung aufweisen. Die erste Anschlussanordnung kann insbesondere an einer Halterung des Transportwagens aufgenommen sein, wie einer Tragplatte, einem Tragrahmen, einen Tragprofil oder dergleichen.

Der Transportwagen kann mittels der mechanischen Arretierung ausrichtbar und arretierbar sein.

Alternativ oder ergänzend kann vorgesehen sein, dass das Transportsystem ein Transportband aufweist. Insbesondere kann vorgesehen sein, dass das Transportsystem Werkstückträger aufweist, die zum Aufnehmen einer jeweiligen zu prüfenden Batterie eingerichtet sind, wobei die Batterie mittels eines zugeordneten Werkstückträgers auf dem Transportband verfahrbar ist.

Wie zuvor bereits dargelegt, kann die Schnittstelle Kontaktelemente zum Herstellen einer elektrisch leitenden Verbindung aufweisen, wie einer Steckverbindung mit Pin und Buchse oder dergleichen.

Es kann vorgesehen sein, dass die Schnittstelle Kontaktelemente zum Herstellen einer Fluidverbindung aufweist, wie eine Fluidkupplung oder dergleichen, zur Einbringung von Gas zur Dichtigkeitsprüfung in eine in der Prüfposition angeordnete Batterie, wobei insbesondere ein Inertgas, wie Helium oder dergleichen, zur Dichtigkeitsprüfung über die Schnittstelle bereitstellbar ist.

Die Schnittstelle kann zur Leistungsversorgung der Batterie für eine Leistungsprüfung und zur Gasversorgung der Batterie für eine Dichtigkeitsprüfung eingerichtet sein.

Insbesondere kann vorgesehen sein, dass die Vorrichtung zur gleichzeitigen Dichtigkeitsprüfung und Leistungsprüfung einer in der Prüfposition angeordneten Batterie eingerichtet ist, wobei die Schnittstelle sowohl zur Versorgung der in der Prüfposition angeordneten Batterie mit elektrischer Leistung als auch zur Einbringung von Gas in die in der Prüfposition angeordnete Batterie eingerichtet ist.

Die gleichzeitige Prüfung der Dichtigkeit und der Leistung hat den Vorteil, dass innerhalb der Batterie durch das Gas eine nur schwer entflammbare bzw. brandhemmende Atmosphäre geschaffen wird, sodass die Brandentwicklung und Rauchentwicklung im Falle eines Defekts gehemmt werden können.

Es kann ein Temperatursensor zur Überwachung einer Temperatur der zu prüfenden Batterie vorgesehen sein, wobei der Temperatursensor insbesondere zur Überwachung einer Temperatur im Inneren der zu prüfenden Batterie vorgesehen ist.

Alternativ oder ergänzend kann ein Rauchgassensor zur Überwachung einer Rauchentwicklung einer zu prüfenden Batterie vorgesehen sein.

Die vorgenannten Sensoren dienen zur Überwachung der Batterie während der Leistungsprüfung, d. h. während des Ladens und/oder Entladens der Batterie, und/oder während einer Hochvoltprüfung.

Es kann vorgesehen sein, dass die Brandschutzhaube in Abhängigkeit von einem Signal des Temperatursensors und/oder des Rauchgassensors automatisiert absenkbar ist.

Beispielsweise kann vorgesehen sein, dass ein Antrieb und ein Kupplungselement, die als Teil einer Handhabungsvorrichtung zum Halten und Bewegen der Brandschutzhaube vorgesehen sind, mittels einer Steuerung anhand der Signale der vorgenannten Sensoren steuerbar sind. Soweit beispielsweise ein Schwellwert für eine Temperatur der Batterie, insbesondere im Inneren der Batterie, überschritten wird, kann das Absenken der Brandschutzhaube mittels der Handhabungsvorrichtung eingeleitet werden. Dies gilt gleichermaßen, soweit alternativ oder ergänzend beispielsweise ein Überschreiten eines Schwellwerts für eine Rauchgaskonzentration durch den Rauchgassensor detektiert wird.

Nach dem Absenken der Brandschutzhaube auf das Transportsystem wird die Brandschutzhaube entkoppelt und es kann ein Abtransport der Batterie aus der Prüfposition ebenfalls automatisiert mittels der Steuerung ausgelöst werden.

Weiter können alternativ oder ergänzend vor dem Absenken der Brandschutzhaube die Schnittstelle und/oder eine Arretierung automatisiert mittels der Steuerung lösbar sein, um beispielsweise einen Transportwagen des Transportsystems beispielsweise vollständig mechanisch von einer Tragstruktur zu Entkoppeln.

Es kann vorgesehen sein, dass die Schnittstelle Kontaktelemente zum Herstellen einer Fluidverbindung aufweist, wie einer Fluidkupplung oder dergleichen, zur Einbringung von Kühlmedium in einen Kühlkreislauf der in der Prüfposition angeordneten Batterie. Die Batterie kann daher während eines Prüfvorgangs temperiert werden. Insbesondere kann die Schnittstelle eine erste Fluidkupplung zum Einbringen eines Gases und eine zweite Fluidkupplung zur Einbringung eines Kühlmediums aufweisen, so dass die Batterie während einer Leistungsprüfung gleichzeitig mit Gas befüllbar und mit einem Kühlmedium versorgbar ist.

Gemäß einem zweiten Aspekt betrifft die Erfindung ein Verfahren zum Prüfen einer Batterie, mit den Verfahrensschritten: Bereitstellen der zu prüfenden Batterie auf einem Transportsystem; Transport der Batterie in eine Prüfposition mittels des Transportsystems; Versorgung der zu prüfenden Batterie mit elektrischer Leistung und mit Gas über eine Schnittstelle.

Gemäß einer Ausgestaltung des Verfahrens ist vorgesehen, dass die zu prüfende Batterie über die Schnittstelle sowohl mit elektrischer Leistung versorgt wird als auch mit einem Gas befüllt wird, wobei gleichzeitig sowohl eine Leistungsprüfung als auch eine Dichtigkeitsprüfung der Batterie durchgeführt werden.

Wie bereits diskutiert, hat die gleichzeitige Dichtigkeitsprüfung zusammen mit der Leistungsprüfung den Vorteil, dass innerhalb der Batterie durch das zugeführte Gas, insbesondere Inertgas, eine schwer in flammenbare bzw. brandhemmende Atmosphäre geschaffen werden kann, um die Sicherheit des Testverfahrens und der Testumgebung insgesamt zu erhöhen.

Während der Dichtigkeitsprüfung wird eine Sonde entlang der Batterie geführt, um aus der Batterie austretendes Gas zu detektieren. Die Dichtigkeitsprüfung wird vorliegend daher insbesondere als eine sogenannte Schnüffelprüfung durchgeführt.

Es kann vorgesehen sein, dass wobei eine auf das Transportsystem absenkbare Brandschutzhaube zum Abschirmen der zu prüfenden Batterie gegenüber einer Umgebung bereitgestellt ist.

Das Verfahren hat den Vorteil, dass mittels der Brandschutzhaube die Sicherheit der Prüfung einer Batterie verbessert werden kann.

Alle zuvor bezüglich der erfindungsgemäßen Vorrichtung genannten Verfahrensschritten können Gegenstand des beschriebenen erfindungsgemäßen Verfahrens sein.

Das erfindungsgemäße Verfahren kann mittels einer voranstehend beschriebenen erfindungsgemäßen Vorrichtung durchgeführt werden.

Gemäß einer Ausgestaltung des Verfahrens kann vorgesehen sein, dass während und/oder nach der Versorgung der zu prüfenden Batterie mit elektrischer Leistung und/oder während eines Entladens der Batterie eine Temperatur der zu prüfenden Batterie überwacht wird, insbesondere eine Temperatur im Inneren der Batterie überwacht wird, und/oder eine Rauchentwicklung der zu prüfenden Batterie überwacht wird, und die Brandschutzhaube zum Abschirmen der zu prüfenden Batterie abgesenkt wird, sofern ein Schwellwert der Temperatur und/oder ein Schwellwert der Rauchentwicklung überschritten wird.

Die Begriffe Rauchgasentwicklung und Rauchentwicklung werden im vorliegenden Text synonym verwendet. Wenn vorliegend von einer Batterie oder von einer zu prüfenden Batterie gesprochen wird, so betrifft dies jeweils eine Batterie, die mittels der erfindungsgemäßen Vorrichtung bzw. mittels des erfindungsgemäßen Verfahrens geprüft wird.

Es kann vorgesehen sein, dass die Brandschutzhaube nach dem Absenken auf das Transportsystem automatisiert von einer Handhabungseinrichtung, die die Brandschutzhaube trägt, entkoppelt wird. Sowohl das Absenken als auch das Entkoppeln können vollständig automatisiert erfolgen.

Gemäß einer Ausgestaltung des Verfahrens ist vorgesehen, dass die Batterie nach dem Absenken und Entkoppeln der Brandschutzhaube automatisiert aus der Prüfposition abtransportiert wird.

Falls eine Batterie in Brand gerät und/oder eine Rauchgasentwicklung stattfindet, kann die Batterie daher insbesondere vollständig automatisiert gegenüber einer Umgebung gekapselt bzw. abgeschirmt werden und aus der Prüfposition abtransportiert werden, um eine Verletzung von Personen oder eine Beschädigung der Vorrichtung oder umliegender Fertigungseinrichtungen oder des die Fertigungseinrichtungen beherbergenden Gebäudes zu vermeiden.

Gemäß einer Ausgestaltung des Verfahrens ist vorgesehen, dass die Schnittstelle vor dem Absenken der Brandschutzhaube und/oder während des Absenkens der Brandschutzhaube automatisch entkoppelt wird. Insbesondere für den Fall, dass die Schnittstelle innerhalb eines Absenkwegs angeordnet ist, den die Brandschutzhaube ausgehend von einer Warteposition bis zu einem vollständig auf das Transportsystem abgesenkten Zustand durchläuft, kann das automatisierte Trennen der Schnittstelle ein zügiges und insbesondere unterbrechungsfreies Absenken der Brandschutzhaube auf das Transportsystem ermöglichen, um die Batterie schnellstmöglich gegenüber einer Umgebung abzuschirmen bzw. zu kapseln.

Es kann vorgesehen sein, dass ein Transportwagen des Transportsystems mittels einer mechanischen Arretierung arretiert und/oder ausgerichtet wird, um die zu prüfende Batterie in der Prüfposition zu Positionieren. Weiter kann vorgesehen sein, dass die mechanische Arretierung nach dem Absenken der Brandschutzhaube automatisiert entkoppelt wird. Insbesondere kann vorgesehen sein, dass sowohl das Entkoppeln der Arretierung als auch das Entkoppeln der Schnittstelle vollständig automatisiert erfolgen, um zügig eine vollständige mechanische Entkopplung eines Transportwagens von beispielsweise einer Tragstruktur zu gewährleisten, die einen Teil der Arretierung und einen Teil der Schnittstelle trägt. Auf diese Weise kann ein schneller Abtransport einer in Brand geratenen Batterie ermöglicht werden.

Alternativ oder ergänzend kann vorgesehen sein, dass die zu prüfende Batterie über die Schnittstelle mit einem Kühlfluid zum Kühlen der Batterie versorgt wird.

Nachfolgend wird die Erfindung anhand einer Ausführungsbeispiele darstellenden Zeichnung näher beschrieben. Es zeigen jeweils schematisch:
- Fig. 1: eine erfindungsgemäße Vorrichtung in einer perspektivischen Ansicht;
- Fig. 2: die Vorrichtung aus Fig. 1 in einer weiteren perspektivischen Ansicht;

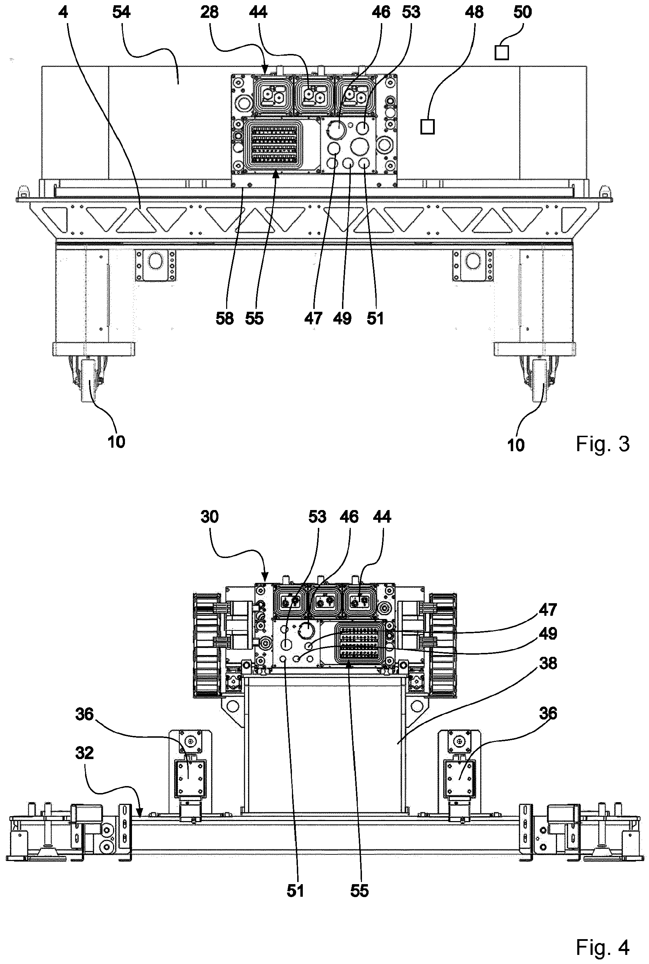

- Fig. 3: eine erste Anschlussanordnung einer Schnittstelle;
- Fig. 4: eine zweite Anschlussanordnung einer Schnittstelle;
- Fig. 5: die Vorrichtung aus Fig. 1 mit der Brandschutzhaube in Wartestellung;
- Fig. 6: die Vorrichtung aus Fig. 1 mit der Brandschutzhaube in einer auf den Transportwagen abgesenkten Position;
- Fig. 7: die Schnittstelle in einer Seitenansicht im gekoppelten Zustand;
- Fig. 8: die Schnittstelle in einer Seitenansicht im entkoppelten Zustand;
- Fig. 9: die Schnittstelle in einer Seitenansicht im entkoppelten Zustand mit der Brandschutzhaube in einer auf den Transportwagen abgesenkten Position;
- Fig. 10: die Schnittstelle in einer Seitenansicht im entkoppelten Zustand mit der Brandschutzhaube in einer auf den Transportwagen abgesenkten Position, mit teiltransparent dargestellter Brandschutzhaube;
- Fig. 11: der Transportwagen mit der Brandschutzhaube beim Abtransport;
- Fig. 12: eine mechanische Verriegelung des Transportwagens in der Prüfposition;
- Fig. 13: die Brandschutzhaube in einer perspektivischen Ansicht von oben;
- Fig. 14: eine Ausschnittvergrößerung der Fig. 13;
- Fig. 15: die Brandschutzhaube in einer perspektivischen Ansicht von unten

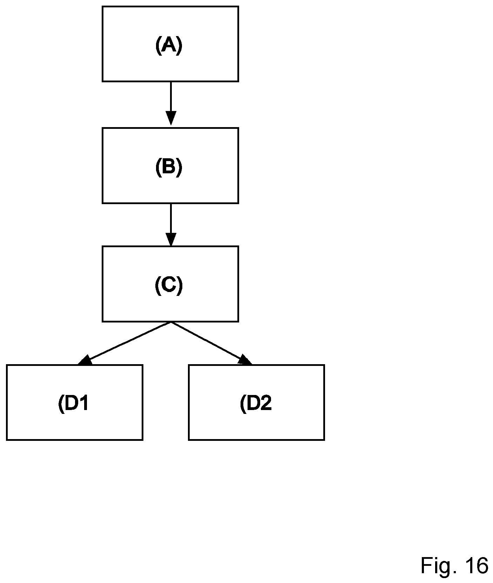

- Fig. 16: einen Ablaufplan eines erfindungsgemäßen Verfahrens.

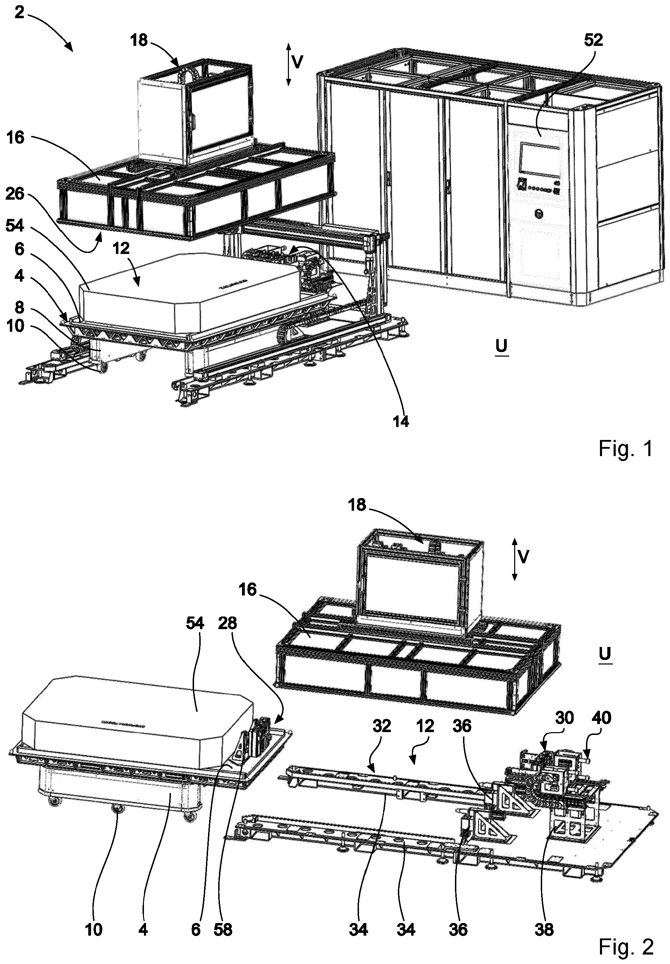

Fig. 1 zeigt eine Vorrichtung 2 zur Prüfung einer Batterie 54. Die Vorrichtung 2 hat ein Transportsystem 4 in Form eines Transportwagens 4. Der Transportwagen 4 hat eine Stellfläche 6 zum Aufnehmen der zu prüfenden Batterie 54. Der Transportwagen 4 hat ein Antriebssystem 8 und Rollen 10 zum automatisierten und/oder manuellen Bewegen des Transportwagens 4.

Der Transportwagen 4 ist zum Transport der zu prüfenden Batterie 54 hin zu einer Prüfposition 12 und zum Abtransport der betreffenden zu prüfenden Batterie 54 aus der Prüfposition 12 eingerichtet.

Die Vorrichtung 2 hat eine Schnittstelle 14, wobei die Schnittstelle 14 zur Versorgung einer in der Prüfposition 12 angeordneten Batterie 54 mit elektrischer Leistung, mit einem Gas bzw. Prüfgas und mit einem Kühlfluid eingerichtet ist.

Die Vorrichtung 2 hat eine auf den Transportwagen 4 absenkbare Brandschutzhaube 16 zum Abschirmen der zu prüfenden Batterie 54 gegenüber einer Umgebung U.

Die Brandschutzhaube 16 ist automatisiert auf den Transportwagen 4 absenkbar. Hierzu ist die Brandschutzhaube 16 in vertikaler Richtung V betrachtet oberhalb der Prüfposition 12 in einer Wartestellung positioniert.

Fig. 1 zeigt die Brandschutzhaube 16 in ihrer Wartestellung. Die Brandschutzhaube 16 ist vorliegend in einer rein linearen Bewegung entlang der vertikalen Richtung V auf den Transportwagen 4 absenkbar.

Die Brandschutzhaube 16 ist an einer Handhabungseinrichtung 18 befestigt wobei die Handhabungseinrichtung 18 zum automatisierten Absenken und Anheben der Brandschutzhaube 16 eingerichtet ist und zudem zum Halten der Brandschutzhaube 16 in der in Fig. 1 dargestellten Wartestellung eingerichtet ist.

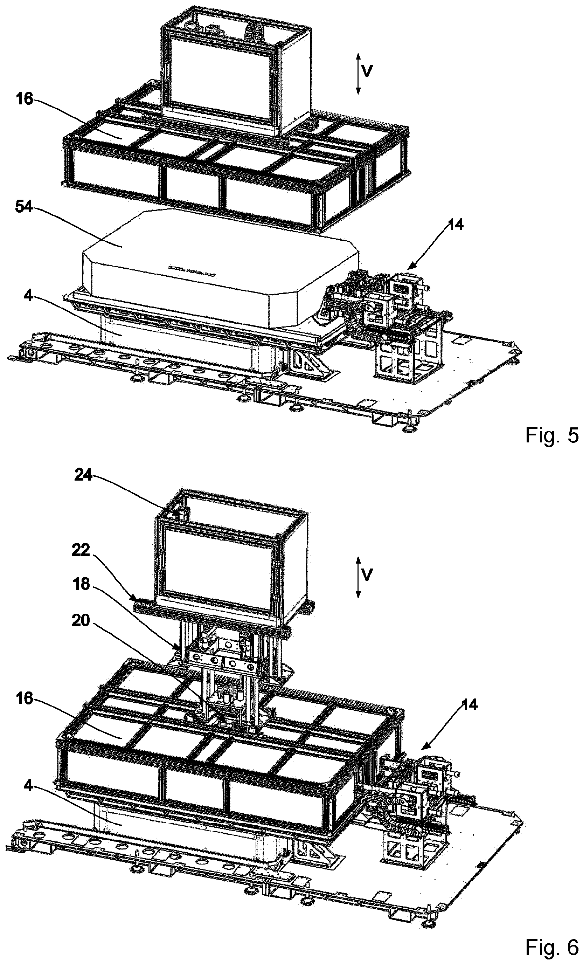

Die Handhabungseinrichtung 18 weist eine Kupplung 20 (Fig. 6) zum Koppeln der Brandschutzhaube 16 mit der Handhabungseinrichtung 18 und zum Entkoppeln der Brandschutzhaube 16 von der Handhabungseinrichtung 18 auf.

Die Handhabungseinrichtung 18 weist einen in vertikaler Richtung V betrachtet oberhalb der Prüfposition 12 angeordneten Träger 22 auf, an dem eine Achse 24 der Handhabungseinrichtung 18 zum Absenken und Anheben der Brandschutzhaube 16 angeordnet ist. Die Achse 24 ist vorliegend eine Linearachse 24 in Form eines Pneumatikzylinders 24, der zum Bewegen der Brandschutzhaube 16 entlang der vertikalen Richtung V eingerichtet ist.

Die Brandschutzhaube 16 ist im wesentlichen quaderförmig ausgebildet. Die Brandschutzhaube 16 weist eine der Prüfposition 12 zugewandte Öffnung 26 auf.

Die Schnittstelle 14 hat eine erste Anschlussanordnung 28 die an dem Transportwagen 4 befestigt ist. Die Schnittstelle 14 hat eine zweite Anschlussanordnung 30 die mit der ersten Anschlussanordnung 28 verbindbar ist, wobei die erste Anschlussanordnung 28 mittels des Transportwagens 4 relativ zu der zweiten Anschlussanordnung 30 bewegbar ist.

Die Prüfposition 12 ist durch eine Tragstruktur 32 vorgegeben. Die zweite Anschlussanordnung 30 ist an der Tragstruktur 32 befestigt.

Die Prüfposition 12 der Batterie 54 entspricht einer Parkposition 12 des Transportwagens 4 unterhalb der Brandschutzhaube 16, da die Batterie 54 mittels des Transportwagens 4 positioniert wird. Die Tragstruktur 32 hat parallel zueinander erschreckte Seitenschienen 34, die die Parkposition 12 des Transportwagens 4 seitlich begrenzen.

Die Tragstruktur 32 hat zwei Anschläge 36, die eine stirnseitigen Begrenzung eines Verfahrwegs des Transportwagens 4 beim Einfahren in die Parkposition 12 darstellen.

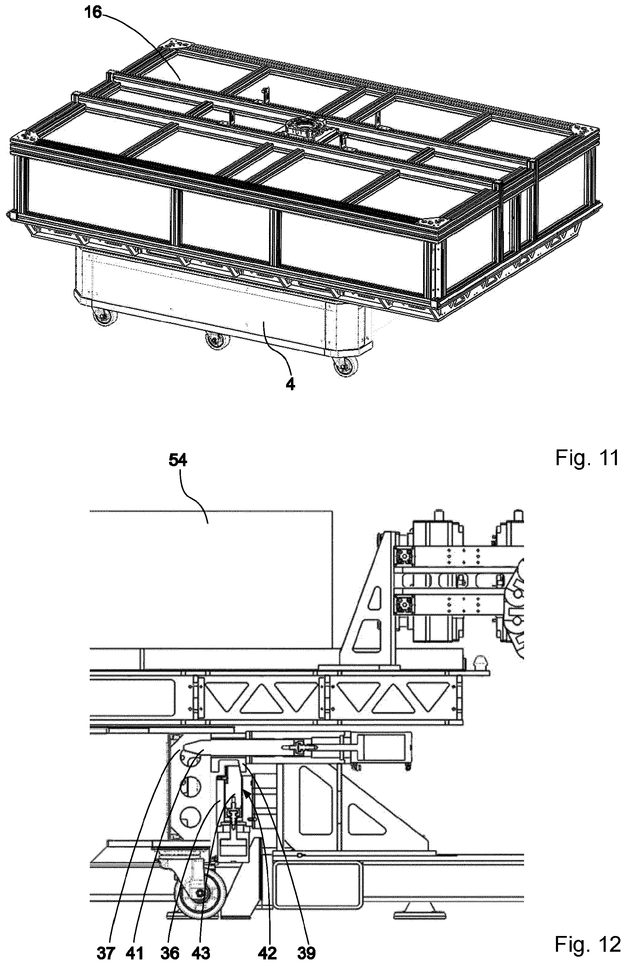

An den Anschlägen 36 ist eine mechanische Arretierung 42 vorgesehen, die dazu eingerichtet ist, den Transportwagen 4 an der Tragstruktur 32 auszurichten und zu fixieren (Fig. 12). Die mechanische Arretierung 42 hat an jedem Anschlag 26 jeweils ein vertikal verschiebbares Rastelement 43 zum formschlüssigen Festlegen des Transportwagen 4 an der Tragstruktur 32 und jeweils ein horizontal verschiebbares Zentrierelement 41 zum formschlüssigen Zentrieren des Transportwagens 4 an der Tragstruktur 32. Die Rastelemente 43 und Zentrierelemente 41 greifen jeweils in zugeordnete Formelemente 37, 39 des Transportwagens 4 ein.

Die Tragstruktur 32 hat eine Halterung 38, die die zweite Anschlussanordnung 30 der Schnittstelle 14 trägt. Die zweite Anschlussanordnung 30 ist mittels der Halterung 38 an der Tragstruktur 32 befestigt. Die erste Anschlussanordnung 28 ist an einer Halterung 58 des Transportwagens 4 aufgenommen.

Die Schnittstelle 14 ist automatisiert koppelbar und entkoppelbar wobei die Schnittstelle 14 einen mechanischen Aktuator 40 zum automatisierten Koppeln und Entkoppeln der Schnittstelle 14 aufweist.

Der mechanische Aktuator 40 ist an der Halterung 38 befestigt und zum Ausführen einer linearen Hubbewegung in Richtung des Transportwagens 4 vorgesehen. Der mechanische Aktuator 40 trägt daher die zweite Anschlussanordnung 30 und ist dazu vorgesehen, die zweite Anschlussanordnung 30 in Richtung der ersten Anschlussanordnung 28 zu verschieben, um diese miteinander zu koppeln, soweit sich der Transportwagen 4 in der Prüfposition 12 befindet.

Die Schnittstelle 14 hat Kontaktelemente 44 zum Herstellen einer elektrisch leitenden Steckverbindung. Die Kontaktelemente 44 dienen zur Übertragung einer elektrischen Ladeleistung oder Entladeleistung im Zuge einer Leistungsprüfung der zu prüfenden Batterie 54.

Die Schnittstelle 14 hat Kontaktelemente 46 zum Herstellen einer Fluidverbindung zum Einleiten von Prüfgas zur Dichtigkeitsprüfung. Die Kontaktelemente 46 bilden eine Fluidkupplung. Die Kontaktelemente 46 dienen zum Einbringen von Gas zur Dichtigkeitsprüfung in die zu prüfende Batterie 54.

Die Schnittstelle 14 hat Kontaktelemente 47, 49 zum Herstellen einer Fluidverbindung zum Einleiten von Kühlmedium zur Temperierung in die zu prüfende Batterie 54, und zwar einen Vorlauf 47 und einen Rücklauf 49. Die Kontaktelemente 47, 49 bilden jeweils eine Fluidkupplung. Die Kontaktelemente 47, 49 dienen zur Einbringung von Kühlmedium in einen Kühlkreislauf der zu prüfenden Batterie 54.

Weiter sind Kontaktelemente 51 einer Messleitung, Kontaktelemente 53 einer Hilfsspannungsversorgung sowie Kontaktelemente 55 eines CAN BUS zum Übermitteln von Steuersignalen an der Schnittstelle 14 vorgesehen.

Die Vorrichtung 2 ist zur gleichzeitigen Dichtigkeitsprüfung und Leistungsprüfung einer in der Prüfposition angeordneten Batterie eingerichtet.

Zur Überwachung eines Prüfvorgangs sind ein Temperatursensor 48 zur Überwachung einer Temperatur im Inneren der zu prüfenden Batterie vorgesehen und ein Rauchgassensor 50 zur Überwachung einer Rauchentwicklung einer zu prüfenden Batterie vorgesehen.

Die Vorrichtung 2 weist eine Steuerung 52 auf, die zur Durchführung der Leistungsprüfung und der Dichtigkeitsprüfung der zu prüfenden Batterie 54 eingerichtet ist.

Die Steuerung 52 ist weiter dazu eingerichtet, die Brandschutzhaube 16 in Abhängigkeit von einem Signal des Temperatursensors 48 und/oder des Rauchgassensors 50 auf den Transportwagen 4 abzusenken.

Nachfolgend wird die Funktionsweise der erfindungsgemäßen Vorrichtung 2 anhand eines erfindungsgemäßen Verfahrens beschrieben.

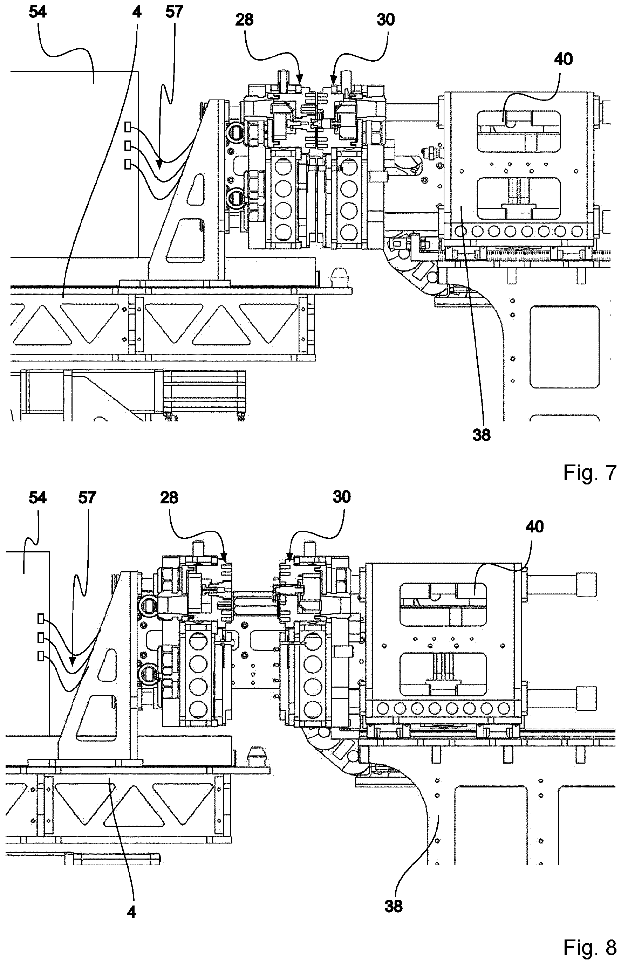

In einem ersten Verfahrensschritt (A) wird zunächst die zu prüfende Batterie 54 auf dem Transportwagen 4 bereitgestellt (Fig. 2) und mit der ersten Anschlussanordnung 28 verbunden. Verbindungen 57 zwischen der ersten Anschlussanordnung 28 und der Batterie 54 sind in Fig. 7 und Fig. 8 schematisch angedeutet.

Die zu prüfende Batterie 54 wird in einem Verfahrensschritt (B) auf dem Transportwagen 4 in die Prüfposition 12 gefahren (Fig. 1, Fig. 5). Der Transportwagen 4 wird mittels der mechanischen Arretierung 42 ausgerichtet bzw. zentriert und an der Tragstruktur 32 fixiert.

Anschließend wird die Schnittstelle 14 gekoppelt, in dem die zweite Anschlussanordnung 30 mittels des mechanischen Aktuators 40 aus der Position gemäß Fig. 8 in Richtung der ersten Anschlussanordnung 28 bewegt wird, sodass eine Steckverbindung zwischen der ersten Anschlussanordnung 28 und der zweiten Anschlussanordnung 30 gebildet ist, wie in Fig. 7 gezeigt.

In einem dritten Verfahrensschritt (C) erfolgt gleichzeitig eine Leistungsprüfung und eine Dichtigkeitsprüfung der Batterie 54, wobei die Batterie 54 über die Schnittstelle 14 sowohl mit elektrischer Leistung versorgt wird und gleichzeitig mit Gas befüllt wird. Währenddessen erfolgt auch eine Einbringung von Kühlmedium über die Schnittstelle 14.

Sofern die Prüfung problemlos verläuft, wird die Batterie 54 automatisiert wieder aus der Prüfposition 12 abtransportiert (vgl. Fig. 2), wobei vor dem Abtransport die Schnittstelle 12 sowie die mechanische Arretierung 42 entkoppelt werden (Verfahrensschritt D1). Für den Fall einer problemlosen Prüfung verbleibt die Brandschutzhaube 16 dauerhaft in ihrer in den Figuren 1, 2 und 5 gezeigten Wartestellung.

Falls einer der Sensoren 48, 50 die Überschreitung eines vorgegebenen Schwellwerts detektiert, d. h. zum Beispiel eine zu hohe Temperatur im Inneren der Batterie 54 oder eine zu hohe Rauchgasentwicklung, wird die Brandschutzhaube 16 auf den Transportwagen 4 abgesenkt, um die Batterie 54 gegenüber der Umgebung U zu kapseln bzw. abzuschirmen (Fig. 6, Fig. 9, Fig. 10).

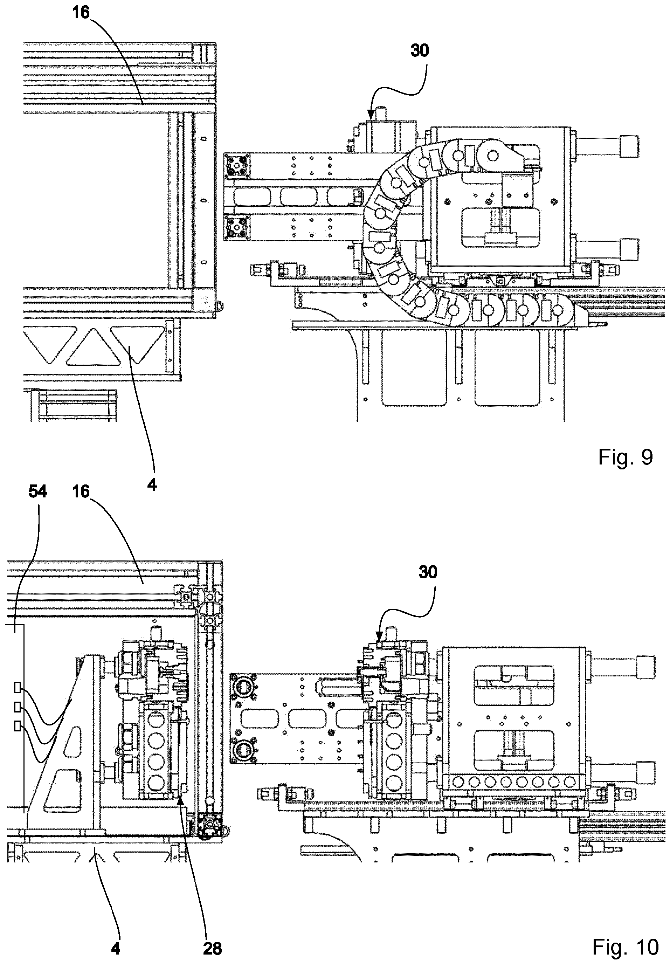

Vor und/oder während des Absenkens der Brandschutzhaube 16 wird die Schnittstelle 14 entkoppelt. Die Brandschutzhaube 16 schirmt im vollständig auf den Transportwagen 4 abgesenkten Zustand sowohl die Batterie 54 als auch die erste Anschlussanordnung 28 gegenüber der Umgebung U ab (Fig. 9, Fig. 10).

Nach dem Absenken der Brandschutzhaube 16 auf den Transportwagen 4 wird die Brandschutzhaube 16 von der Handhabungseinrichtung 18 entkoppelt und auch die Arretierung 42 an der Tragstruktur 32 wird gelöst bzw. entkoppelt. Es besteht daher keine mechanische Verbindung mehr zwischen dem Transportwagen 4 und der Tragstruktur 32. Der Transportwagen 4 kann die in Brand geratene Batterie 54 zusammen mit der auf den Transportwagen 4 abgesenkten Brandschutzhaube 16 aus der Prüfposition 12 abtransportieren, wie exemplarisch in Fig. 11 gezeigt (Verfahrensschritt D2).

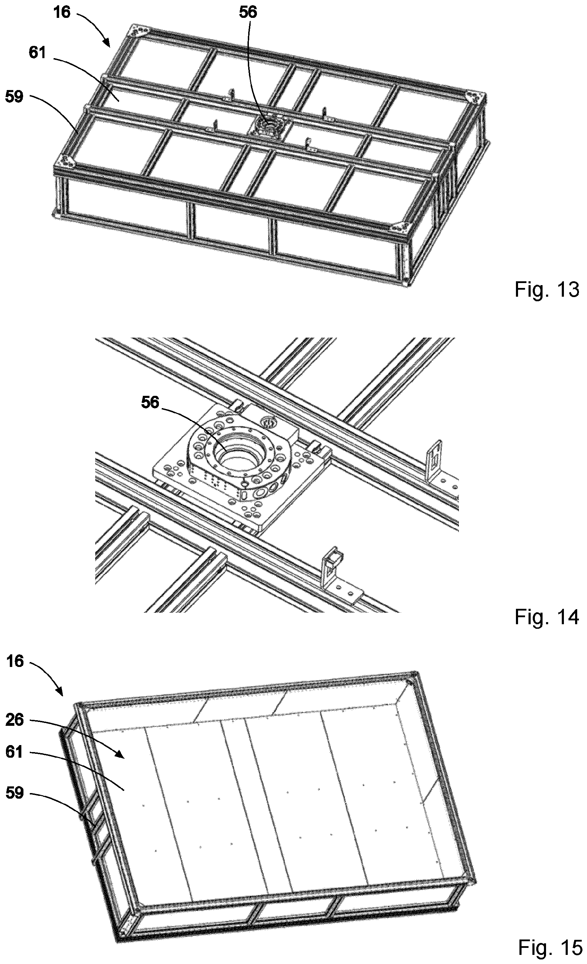

Fig. 13 zeigt die Brandschutzhaube 16 in einzelner Darstellung mit einer Ausschnittvergrößerung eines Anschlussstücks 56 (Fig. 14) zum Koppeln der Brandschutzhaube 16 mit der Handhabungseinrichtung 18.

Die Brandschutzhaube 16 hat eine Skelettbauweise und weist ein Rahmenskelett 59 mit flächigen Füllelementen 61 auf. Die flächigen Füllelementen 61 sind Brandschutzplatten.

Das Rahmenskelett 59 ist zumindest teilweise aus Aluminium bzw. Aluminiumlegierungen gebildet. Die Brandschutzplatten 61 weisen ein nicht brennbares Füllmaterial auf. Die Brandschutzplatten 61 sind lösbar und austauschbar an dem Rahmenskelett 59 gehalten und sind vorliegend mit dem Rahmenskelett 59 verschraubt.

### Bezugszeichen

- 2: Vorrichtung
- 4: Transportwagen
- 6: Stellfläche
- 8: Antriebssystem
- 10: Rollen
- 12: Prüfposition / Parkposition
- 14: Schnittstelle
- 16: Brandschutzhaube
- 18: Handhabungseinrichtung
- 20: Kupplung
- 22: Träger
- 24: Linearachse
- 26: Öffnung
- 28: erste Anschlussanordnung
- 30: zweite Anschlussanordnung
- 32: Tragstruktur
- 34: Schiene
- 36: Anschlag
- 37: Formelement
- 38: Halterung
- 39: Formelement
- 40: Aktuator
- 41: Zentrierelement / Stellelement
- 42: Arretierung
- 43: Rastelement / Stellelement
- 44: Kontaktelemente
- 46: Kontaktelemente
- 47: Kontaktelemente
- 48: Temperatursensor
- 49: Kontaktelemente
- 50: Rauchgassensor
- 51: Kontaktelemente
- 52: Steuerung
- 53: Kontaktelemente
- 54: Batterie
- 55: Kontaktelemente
- 56: Anschlussstück
- 57: Verbindungen
- 58: Halterung
- 59: Rahmenskelett
- 61: Füllelemente / Brandschutzplatten
- (A): Verfahrensschritt
- (B): Verfahrensschritt
- (C): Verfahrensschritt
- (D1): Verfahrensschritt
- (D2): Verfahrensschritt
- V: vertikale Richtung / Vertikale

## Patentansprüche

1. Vorrichtung zur Prüfung einer Batterie,
- mit einem Transportsystem (4), wobei das Transportsystem (4)
- zum Aufnehmen der Batterie (54),
- zum Transport der Batterie (54) hin zu einer Prüfposition (12) und
- zum Abtransport der Batterie (54) aus der Prüfposition (12) eingerichtet ist;
- mit einer Schnittstelle (14),
- wobei die Schnittstelle (14) zur Versorgung der in der Prüfposition (12) angeordneten Batterie (54) mit elektrischer Leistung eingerichtet ist; und
- wobei die Schnittstelle (14) zur Versorgung der in der Prüfposition (12) angeordneten Batterie (54) mit Gas eingerichtet ist.

2. Vorrichtung nach Anspruch 1,
**dadurch gekennzeichnet, dass**
- eine auf das Transportsystem (4) absenkbaren Brandschutzhaube (16) zum Abschirmen der Batterie (54) gegenüber einer Umgebung (U) vorgesehen ist, wobei die Brandschutzhaube (16) insbesondere automatisiert absenkbar ist, insbesondere,
- dass die Brandschutzhaube (16) in vertikaler Richtung (V) betrachtet oberhalb der Prüfposition (12) in einer Wartestellung positionierbar ist und aus der Wartestellung auf die zu prüfende, in der Prüfposition (12) angeordnete Batterie (54) absenkbar ist, insbesondere,
- dass die Brandschutzhaube (16) in einer rein linearen Bewegung auf das Transportsystem (4) absenkbar ist, insbesondere,
- dass eine Handhabungseinrichtung (18) vorgesehen ist, wobei die Handhabungseinrichtung (18) zum automatisierten Absenken und Anheben der Brandschutzhaube (16) eingerichtet ist, wobei die Handhabungseinrichtung (18) insbesondere eine Kupplung (20) zum Koppeln der Brandschutzhaube (16) mit der

3. Vorrichtung nach einem der voranstehenden Ansprüche,
**dadurch gekennzeichnet, dass**
- die Schnittstelle (14) eine erste Anschlussanordnung (28) hat, die an dem Transportsystem (4) befestigt ist und
- die Schnittstelle (14) eine zweite Anschlussanordnung (30) hat, die mit der ersten Anschlussanordnung (28) verbindbar ist,
- wobei die erste Anschlussanordnung (28) mittels des Transportsystems (4) relativ zu der zweiten Anschlussanordnung (30) bewegbar ist.

4. Vorrichtung nach Anspruch 2 und Anspruch 3,
**dadurch gekennzeichnet, dass**
- die Brandschutzhaube (16) die erste Anschlussanordnung (28) in einem auf das Transportsystem (4) abgesenkten Zustand abdeckt und gegenüber der Umgebung (U) abschirmt und
- die Brandschutzhaube (U) insbesondere die zweite Anschlussanordnung (30) in dem auf das Transportsystem abgesenkten Zustand nicht abdeckt.

5. Vorrichtung nach einem der voranstehenden Ansprüche,
**dadurch gekennzeichnet, dass**
- die Schnittstelle (14) automatisiert koppelbar und entkoppelbar ist, wobei der Schnittstelle (14) insbesondere ein mechanischer Aktuator (40) zum automatisierten Koppeln und Entkoppeln der Schnittstelle (14) zugeordnet ist.
und/oder
- mindestens eine mechanische Arretierung (42) vorgesehen ist, um die zu prüfende Batterie (54) und/oder ein Transportsystem (4) in der Prüfposition (12) zu arretieren und/oder auszurichten, wobei die mechanische Arretierung (42) insbesondere automatisiert koppelbar und entkoppelbar ist.
und/oder
- die Schnittstelle (14) Kontaktelemente (44) zum Herstellen einer elektrisch leitenden Verbindung aufweist, wie eine Steckverbindung mit Pin und Buchse oder dergleichen.
Und/oder
- die Schnittstelle (14) Kontaktelemente (46) zum Herstellen einer Fluidverbindung aufweist, wie einer Fluidkupplung oder dergleichen, zur Einbringung von Gas zur Dichtigkeitsprüfung in die in der Prüfposition angeordnete Batterie (54), wobei insbesondere ein Inertgas, wie Helium oder dergleichen, zur Dichtigkeitsprüfung über die Schnittstelle (14) bereitstellbar ist.

6. Vorrichtung nach Anspruch 5,
**dadurch gekennzeichnet, dass**
- die Vorrichtung (2) zur gleichzeitigen Dichtigkeitsprüfung und Leistungsprüfung der in der Prüfposition angeordneten Batterie (54) eingerichtet ist,
- wobei die Schnittstelle (14) sowohl zur Versorgung der in der Prüfposition angeordneten Batterie (54) mit elektrischer Leistung als auch zur Einbringung von Gas in die in der Prüfposition angeordnete Batterie (54) eingerichtet ist.

7. Vorrichtung nach einem der voranstehenden Ansprüche,
**dadurch gekennzeichnet, dass**
- ein Temperatursensor (48) zur Überwachung einer Temperatur der zu prüfenden Batterie (54) vorgesehen ist, insbesondere zur Überwachung einer Temperatur im Inneren der zu prüfenden Batterie (54) vorgesehen ist,
und/oder
- ein Rauchgassensor (50) zur Überwachung einer Rauchentwicklung einer zu prüfenden Batterie (54).

8. Vorrichtung nach Anspruch 7,
**dadurch gekennzeichnet, dass**
die Brandschutzhaube (16) in Abhängigkeit von einem Signal des Temperatursensors (48) und/oder des Rauchgassensors (50) automatisiert absenkbar ist.

9. Vorrichtung nach einem der voranstehenden Ansprüche,
**dadurch gekennzeichnet, dass**
die Schnittstelle (14) Kontaktelemente (47, 49) zum Herstellen einer Fluidverbindung aufweist, wie einer Fluidkupplung oder dergleichen, zur Einbringung von Kühlmedium in einen Kühlkreislauf der in der Prüfposition angeordneten Batterie (54).

10. Verfahren zum Prüfen einer Batterie, mit den Verfahrensschritten:
- Bereitstellen der zu prüfenden Batterie (54) auf einem Transportsystem (4);
- Transport der Batterie (54) in eine Prüfposition (12) mittels des Transportsystems (4);
- Versorgung der zu prüfenden Batterie (54) mit elektrischer Leistung und mit Gas über eine Schnittstelle (14).

11. Verfahren nach Anspruch 10,
**dadurch gekennzeichnet, dass**
eine auf das Transportsystem absenkbare Brandschutzhaube (16) zum Abschirmen der zu prüfenden Batterie (54) gegenüber einer Umgebung (U) bereitgestellt ist.

12. Verfahren nach Anspruch 11,
**dadurch gekennzeichnet, dass**
- während und/oder nach der Versorgung der zu prüfenden Batterie (54) mit elektrischer Leistung und/oder während eines Entladens der Batterie (54) eine Temperatur der zu prüfenden Batterie (54) überwacht wird, insbesondere eine Temperatur im Inneren der zu prüfenden Batterie (54) überwacht wird, und/oder eine Rauchentwicklung der Batterie (54) überwacht wird, und
- die Brandschutzhaube (16) zum Abschirmen der zu prüfenden Batterie (54) auf das Transportsystem (4) abgesenkt wird, sofern ein Schwellwert der Temperatur und/oder ein Schwellwert der Rauchentwicklung überschritten wird.

13. Verfahren nach einem der Ansprüche 10 - 12,
**dadurch gekennzeichnet, dass**
ein Transportwagen (4) des Transportsystems (4) mittels einer mechanischen Arretierung (42) arretiert und/oder ausgerichtet wird, um die zu prüfende Batterie (54) in der Prüfposition (12) zu Positionieren.

14. Verfahren nach Anspruch 13,
**dadurch gekennzeichnet, dass**
die mechanische Arretierung (42) nach dem Absenken der Brandschutzhaube (16) automatisiert entkoppelt wird.

15. Verfahren nach einem der Ansprüche 10 bis 14,
**dadurch gekennzeichnet, dass**
die zu prüfende Batterie (54) über die Schnittstelle (14) sowohl mit elektrischer Leistung versorgt als auch mit einem Gas befüllt wird, wobei gleichzeitig sowohl eine Leistungsprüfung als auch eine Dichtigkeitsprüfung der Batterie (54) durchgeführt werden
und/oder
die zu prüfende Batterie (54) über die Schnittstelle (14) mit einem Kühlfluid zum Kühlen der Batterie (54) versorgt wird.
